# EUROPEAN PATENT APPLICATION

(11) **EP 4 071 271 A1**
(43) Date of publication of application: **12.10.2022**
(21) Application number: 20896912.1
(22) Date of filing: 11.11.2020
(51) Int. Cl.: C23C 16/517, C23C 16/455, C23C 16/26

(54) **COATING APPARATUS AND APPLICATION THEREOF**

(30) Priority: 04.12.2019 CN 201911228781; 20.12.2019 CN 201911326907
(71) Applicant: Jiangsu Favored Nanotechnology Co., Ltd., Yuqi Industry Park, Huishan District Wuxi Jiangsu 214000 (CN)
(72) Inventor: ZONG, Jian, Wuxi, Jiangsu 214112 (CN); TAO, Yongqi, Wuxi, Jiangsu 214112 (CN); LI, Fuxing, Wuxi, Jiangsu 214112 (CN)
(74) Representative: Mewburn Ellis LLP
(86) International application number: PCT/CN2020/128059
(87) International publication number: WO 2021/109813

(57) **Abstract**

Provided in the present disclosure are a coating apparatus and an application thereof, being used for coating on the surface of a substrate, the coating apparatus includes a feeding device and a device main body, wherein the feeding device is configured to communicate with the device main body, the feeding device includes a gas feeding device and a liquid feeding device, the gas feeding device is in communication with the device main body and is used for transmitting a gas raw material to the device main body, the liquid feeding device is in communication with the device main body and is used for transmitting a liquid gasified gas raw material to the device main body, the device main body is used for preparing a thin film based on the gas raw material, and the same coating apparatus can be used for preparing various thin films or film layers with different properties or of different types on the surface of the substrate.

## Description

### TECHNICAL FIELD

The present disclosure relates to the coating field, and further relates to a coating apparatus capable of preparing thin films and its application.

### BACKGROUND

With the development of electronic products, in order to improve the properties of electronic products, such as strength, scratch resistance, wear resistance, heat dissipation, waterproofness, corrosion resistance or low friction, the coating process has become one of indispensable processes. A waterproof film or a waterproof nanofilm formed on the surface of an electronic device through the coating processes can effectively improve the waterproof performance of the electronic product, such as waterproof watches, waterproof mobile phones and other waterproof electronic products in the current market. When the waterproof electronic product is immersed in water, the waterproof film or the waterproof nanofilm can effectively prevent short circuits of internal circuits or external interfaces of USB ports or charging ports, etc, and can prevent moisture from corroding circuit boards or electronic components and the like.

The substrate that requires such film layers includes PCB circuit boards, electronic devices, mobile phones, keyboards, computers, etc. According to types of substrates and the application environment, types and performance of films (or film layers) prepared on the surface of the substrate are also different. For example, current 5G mobile phones, especially full-screen or full-screen curved mobile phones, and flexible screen mobile phones, not only require high light transmittance, high hardness and wear resistance, but also require anti-impact property. Therefore, films formed on a screen or cover of the 5G mobile phones should meet these requirements.

With high hardness, low friction coefficient, high wear resistance, and good chemical stability, thermal conductivity, electrical insulation, light transmittance and biocompatibility, diamond-like carbon film (DLC film) has great application prospect in many fields. The DLC film has the advantages of low deposition temperature, large deposition area, simple deposition conditions and flat and smooth film surface in the preparation process, and has been used in scenarios requiring low deposition temperature and small surface roughness, such as protective coating for computer hard disks, optical discs, etc. With performances of high hardness, low friction coefficient and good wear resistance, DLC films may be used as mechanical antifriction and wear-resistant protective coatings, including tool coatings, magnetic medium protective films and space lubricating materials and the like. With performances of high breakdown voltage and high thermal conductivity, DLC films are applicable in high temperature environments and in high power devices.

In the manufacturing process of Ultra large-scale integration (ULSI) chips, the DLC film has been used as the mask of photoetching circuit board, which not only prevents mechanical damage to the surface caused by repeated contact during operation, but also has strong resistance to mechanical or chemical corrosion. Moreover, the DLC film has relatively low dielectric strength and dielectric constant, and is easy to form a film on a large base, so it is expected to replace SiO₂ as a dielectric material for the next generation of integrated circuits. In addition, with low electron affinity, the DLC film is an excellent cold cathode field emission material which can be used in field emission flat display devices (FED).

With the visible light absorption and infrared transmittance properties, the DLC film can be used as an antireflection film on germanium optical lens and silicon solar cell. Moreover, the DLC film has good light transmittance and is suitable for deposition at low temperature. It can be used as optical lens protective film, optical disc protective film, spectacle lens protective film and windshield protective film of transportation means such as automobiles.

In addition, the DLC film can satisfy the biocompatibility requirements in terms of chemical composition (carbon and hydrogen), and has potential and extensive application prospects in the biomedical field due to its high hardness, low friction coefficient, and chemical inertness, therefore the DLC film has attracted more and more attention. As an example, the deposition of the DLC film on the surface of metallic artificial materials not only greatly improves the compatibility with biological tissues, but also improves the wear resistance of implanted components. The DLC film on the surface of stainless steel or titanium alloy of artificial heart valve can satisfy the requirements of mechanical properties, corrosion resistance and biocompatibility at the same time. Alternatively, the DLC film on artificial joint protheses surface can enhance wear resistance.

However, due to the limitation of the apparatus itself, the coating apparatus on the existing market cannot realize the preparation of thin films with a large area. Types of the prepared films are relatively limited in variety, and the compatibility is extremely poor. Films with only one or one type of property can generally be prepared by the coating apparatus. When multiple layers of films with different properties are needed on the surface of the substrate, it is necessary to use several different types of coating apparatus to coat the substrate respectively. Moreover, some coating apparatus can use gaseous raw materials to prepare films, while liquid raw materials are not suitable, or vice versa. This makes coating apparatus not only poor in applicability, but also high in cost and complicated in operation, which is not conducive to mass production.

Further, the existing coating apparatus usually has corresponding power supply types according to the requirements of the type of coating, which generally includes a radio frequency power supply or a pulse power supply. When a film with two properties is needed on the surface of the substrate to have various properties such as waterproofness and high hardness properties, for example, the preparation of the first film requires the coating equipment using the radio frequency power, while the preparation of the second film requires the coating equipment using the pulse power supply. It is impossible to prepare the first film and the second film on the surface of the substrate by a unified coating apparatus, which makes it impossible to reduce the cost.

Chinese patent publication No. CN1178263A discloses a device for forming a diamond-like carbon film and a method, the device includes a vacuum tank with a predetermined vacuum degree inside, and a substrate base, a substrate temperature adjustment mechanism, and a gas ion source opposite to the substrate are arranged in the vacuum tank; two biasing means for applying voltage are connected on the substrate. A gas ion source and a substrate are configured oppositely with a reaction gas inlet chamber with a flow restriction, a thermionic radiation means, a thermionic extraction electrode and an acceleration electrode. It can be seen that the reaction raw material of the device and the method is gas, which is not applicable to some liquid reaction raw materials, the type of film is relatively single, and films with different properties cannot be prepared, which means the applicability is narrow.

### SUMMARY

An advantage of the present disclosure is to provide a coating apparatus and its application, wherein the coating apparatus is used to form a film or film layers with a large area on a surface of a substrate, so as to achieve mass production of the film.

Another advantage of the present disclosure is to provide a coating apparatus and its application, wherein a variety of films or film layers with different properties or types on a surface of a substrate can be prepared by the coating apparatus.

Another advantage of the present disclosure is to provide a coating apparatus and its application, wherein the coating apparatus is provided with a radio frequency power supply and a pulse power supply, which adaptively apply a corresponding radio frequency electric field and/or a pulse voltage when preparing films with different properties or types.

Another advantage of the present disclosure is to provide a coating apparatus and its application, wherein films with different properties on surfaces of substrates with different types or models can be prepared by the coating apparatus. That is, the coating apparatus can coat respectively substrates with different types or models. Thereby, the properties of films may be diversified, the coating apparatus is compatible, and the cost is low.

Another advantage of the present disclosure is to provide a coating apparatus and its application, wherein films can be prepared by the coating apparatus with using a gas raw material and/or a liquid raw material as raw materials, in other words, a film can be prepared based on a gas raw material by the coating apparatus, and another film can also be prepared based on a liquid raw material by the coating apparatus.

Another advantage of the present disclosure is to provide a coating apparatus and its application, wherein multi-layered films with different types or properties can be prepared by the coating apparatus on a surface of the same substrate, so as to improve more types of properties of the substrate.

Another advantage of the present disclosure is to provide a coating apparatus and its application, wherein the coating apparatus can etch and activate a surface of a substrate, which is beneficial to prepare a film on the surface of the substrate.

Another advantage of the present disclosure is to provide a coating apparatus and its application, wherein the coating apparatus can complete the coating at normal temperature or low temperature, and the coating time is short, which is beneficial to make cost saved.

Another advantage of the present disclosure is to provide a coating apparatus and its application, wherein the coating apparatus can be used to coat some substrates that are not resistant to high temperature, so that the substrates are not easily damaged during the coating process.

Another advantage of the present disclosure is to provide a coating apparatus and its application, wherein the coating apparatus can detect the reaction temperature in real time, so as to further ensure the safety of the substrate.

Another advantage of the present disclosure is to provide a coating apparatus and its application, wherein a film can be prepared by the coating apparatus in combination with radio frequency and/or pulse voltage.

Another advantage of the present disclosure is to provide a coating apparatus and its application, wherein the process of preparing a film by the coating apparatus has good process controllability, which is beneficial to rapidly prepare the target film.

Another advantage of the present disclosure is to provide a coating apparatus and its application, wherein the coating apparatus has a simple structure which is conducive to being cleaned, and has a long service life.

According to an aspect of the present disclosure, the present disclosure provides a coating apparatus for forming a coating on a surface of a substrate, which includes:
a feeding device; and
a device main body, wherein the feeding device is configured to connect with the device main body, the feeding device includes a gas feeding device and a liquid feeding device, the gas feeding device is configured to communicate with the device main body to transmit a gas raw material to the device main body, and the liquid feeding device is configured to communicate with the device main body to transmit a gas raw material gasified from a liquid to the device main body, so that a film is prepared by the device main body based on the gas raw material.

According to some embodiments, the liquid feeding device includes at least one gasification device and at least one first transmitting pipeline, the at least one gasification device is used for gasifying a liquid raw material, and the liquid raw material is gasified into the gas raw material by the gasification device and transmitted to the device main body via the at least one first transmitting pipeline.

According to some embodiments, the liquid feeding device further includes at least one liquid storage device, and the at least one liquid storage device is used for storing the liquid raw material and is configured to communicate with the device main body via the at least one first transmitting pipeline, so that the liquid raw material can be gasified into the gas raw material by the at least one gasification device and transmitted to the device main body.

According to some embodiments, the gasification device is configured between the first transmitting pipeline and the liquid storage device.

According to some embodiments, the gasification device is configured between the first transmitting pipeline and the device main body.

According to some embodiments, the gasification device is configured between two ends of a first transmitting pipeline.

According to some embodiments, the gasification device is implemented as a heating device or a pressure reducing device.

According to some embodiments, the gas feeding device includes at least one second transmitting pipeline, and the at least one second transmitting pipeline is configured to communicate with the device main body, and the gas raw material can be transmitted to the device main body via the at least one second transmitting pipeline.

According to some embodiments, the gas feeding device further includes at least one gas storage device, wherein the at least one gas storage device is used for storing the gas raw material and is configured to communicate with the device main body via the at least one second transmitting pipeline, so that the gas raw material can be transmitted to the device main body.

According to some embodiments, the device main body further includes a power supply device and a chamber body, the chamber body is provided with a chamber, the liquid feeding device and the gas feeding device are both configured to communicate with the chamber of the chamber body to transmit the gas raw material to the chamber, and the power supply device is configured to provide a voltage to apply on the gas raw material in the chamber, such that the film can be prepared on the surface of the substrate by a chemical vapor deposition.

According to some embodiments, the power supply device includes a radio frequency power supply configured to provide a radio frequency electric field to apply on the gas raw material in the chamber.

According to some embodiments, the power supply device includes a pulse power supply configured to provide a pulse voltage to apply on the gas raw material in the chamber.

According to some embodiments, the radio frequency power supply is configured to provide a radio frequency electric field to discharge the gas raw material in the chamber to form a plasma environment and make reactant gases in a high-energy state, and the pulse power supply is configured to provide a pulse voltage to deposit gas particles in a high-energy state to form the film.

According to some embodiments, the device main body further includes a support, wherein the support is configured in the chamber of the chamber body to support the substrate, a positive terminal of the pulse power supply is configured to be electrically coupled with the chamber and grounded, while a negative terminal of the pulse power supply is configured to be electrically coupled with the support, and the support is insulated from the chamber.

According to another aspect of the present disclosure, the present disclosure provides a coating method of a coating apparatus, which includes a step A: forming a first film layer on the surface of a substrate, wherein the step A includes:
A1. transmitting a gas raw material to a device main body; and
A2. forming the first film layer on the surface of the substrate by using the device main body based on the gas raw material.

According to some embodiments, the step A is replaced by a step B: forming a second film layer on the surface of the substrate, wherein the step B includes:
B1. gasifying a liquid raw material into a gas raw material and transmitting the gas raw material to the device main body; and
B2. forming the second film layer on the surface of the substrate by using the device main body based on the gas raw material.

According to some embodiments, the coating method includes the step A and the step B, which are executed successively to prepare the first film layer and the second film layer on the surface of the substrate, or the step A is executed after the step B to prepare the second film layer and the first film layer successively on the surface of the substrate.

According to some embodiments, the step A is replaced by a step C: forming a third film layer on the surface of the substrate, wherein the step C includes:
C1. transmitting a gas raw material to the device main body, and gasifying a liquid raw material into a gas raw material and transmitting the gas raw material to the device main body; and
C2. forming the third film layer on the surface of the substrate by using the device main body based on the gas raw materials.

According to some embodiments, the coating method includes the step A and the step C which are executed successively, or the step A is executed after the step C.

According to some embodiments, the step A1 includes:
A11. storing the gas raw material in a gas storage device; and
A12. transmitting the gas raw material to a chamber of the device main body.

According to some embodiments, the step B1 includes:
B11. storing the liquid raw material in a liquid storage device; and
B12. gasifying the liquid raw material into the gas raw material and transmitting the gas raw material to a chamber of the device main body.

According to some embodiments, the step C1 includes:
C11. storing the liquid raw material in a liquid storage device and storing the gas raw material in a gas storage device;
C12. transmitting the gas raw material to a chamber of the device main body; and
C13. gasifying the liquid raw material into the gas raw material and transmitting the gas raw material to the chamber.

According to some embodiments, the step C12 is executed after the step C13, or the step C12 and the step C13 are executed simultaneously.

According to some embodiments, a liquid raw material is gasified into a gas raw material by means of heating or depressurization.

According to some embodiments, the step A2 includes: providing a radio frequency electric field to apply on the gas raw material to form the first film layer.

According to some embodiments, the step B2 includes: providing a pulse voltage to apply on the gas raw material to form the second film layer.

According to some embodiments, the step C2 includes: providing a radio frequency electric field to discharge the gas raw materials to form a plasma environment and making the reactant gas in a high-energy state, and providing a pulse voltage to deposit gas particles in a high-energy state to form the third film layer.

### BRIEF DESCRIPTION OF THE DRAWINGS

FIG. 1 is a schematic structural diagram of a coating apparatus according to an embodiment of the present disclosure;
FIG. 2 is a schematic structural block diagram of the coating apparatus according to the above embodiment of the present disclosure;
FIG. 3 is a schematic structural block diagram of a feeding device of the coating apparatus according to the above embodiment of the present disclosure;
FIG. 4 is a schematic structural block diagram of a chamber body of the coating apparatus according to the above embodiment of the present disclosure;
FIG. 5 is a schematic structural block diagram of a power supply device of the coating apparatus according to the above embodiment of the present disclosure;
FIG. 6A is a schematic structural block diagram of a feeding device of the coating apparatus according to the above embodiment of the present disclosure;
FIG. 6B is a schematic structural block diagram of another modified embodiment of the feeding device of the coating apparatus according to the above embodiment of the present disclosure; and
FIG. 6C is a schematic structural block diagram of another modified embodiment of the feeding device of the coating apparatus according to the above embodiment of the present disclosure.

### DETAILED DESCRIPTION

The following description serves to disclose the disclosure to enable those skilled in the art to practice the present disclosure. The embodiments in the following description are only for examplification. Those skilled in the art may think of other obvious variations. The basic principles of the present disclosure as defined in the following description may be applied to other embodiments, variations, modifications, equivalents, and other technical solutions without departing from the scope of the present disclosure.

Those skilled in the art will appreciate that, in the disclosure of the present disclosure, the terms "longitudinal", "transverse", "upper", "lower", "front", "rear", "left", "right", "vertical", "horizontal", "top", "bottom", "inner", "outer" and the like indicate azimuth or positional relationships based on the azimuth or positional relationships shown in the drawings. It is only intended to facilitate the description and simplify the description, and not to indicate or imply that the apparatus or element referred to must have a particular orientation, be constructed and operated in a particular orientation, so the above-mentioned terms are not to be construed to limit the present disclosure.

It will be appreciated that the term "a", "an", or "one" is to be understood as "at least one" or "one or more", i.e., in one embodiment, the number of one element may be one and in another embodiment the number of one element may be multiple, and that the term "a", "an", or "one" is not to be construed to limit the number.

In the description of this specification, the description referring to the terms "one embodiment", "some embodiments", "examples", "specific examples", or "some examples" means that the specific features, structures, materials, or characteristics described in connection with the embodiments or examples are included in at least one embodiment or example of the present disclosure. In this specification, the schematic expression of the above terms is not necessarily directed to the same embodiments or examples. Furthermore, the specific features, structures, materials, or characteristics described may be combined in any suitable manner in any one or more embodiments or examples. In addition, without contradiction, those skilled in the art can combine and combine the different embodiments or examples described in this specification and the features of different embodiments or examples.

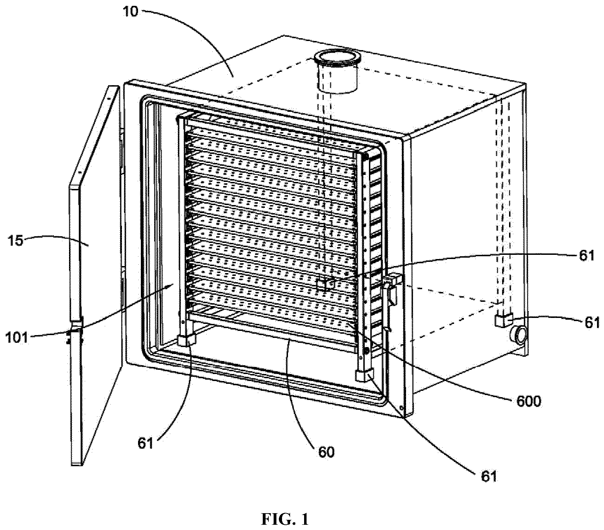

FIG. 1 to FIG. 6C schematically illustrate a coating apparatus 100 according to a preferred embodiment of the present disclosure. The coating apparatus 100 is used to form at least one film or film layers with a large area on a surface of a substrate 600, so the coating apparatus 100 can achieve mass production of the film. Further, a variety of films or film layers with different properties or types on a surface of a substrate can be prepared by the coating apparatus 100. Films with different properties on surfaces of substrates 600 with different types or models can be prepared by the coating apparatus 100. That is, the coating apparatus 100 can coat respectively substrates 100 with different types or models. Thereby, the properties of films may be diversified, the coating apparatus is compatible, and the cost is low.

In some embodiments, the coating apparatus 100 uses a plasma chemical vapor deposition process to prepare a film or film layers on a surface of a substrate 600. That is, the film is deposited and formed on the surface of the substrate 600, so as to improve the mechanical, optical or chemical properties of the surface of the substrate 600. The substrate 600 is a product that needs to be coated with a predetermined shape and structure, such as a PCB circuit board, a mobile phone, an electronic device, an electronic product cover plate, a display screen of an electronic product, a mobile phone glass screen, a computer screen, a mobile phone back cover, an electronic device shell, a keyboard film or other types of products that need to be coated, which is not all enumerated herein. For example, the film prepared by the coating apparatus 100 on a display screen of an electronic product, can effectively strengthen fall resistance and wear resistance of the display screen of the electronic product and lower the cost of surface strengthening.

Further, films with different properties on surfaces of substrates 600 with different types or models can be prepared by the coating apparatus 100. That is, the coating apparatus 100 can coat respectively substrates 600 with different types or models. Thereby, the properties of films may be diversified, the coating apparatus is compatible, and the cost is low. Optionally, the film includes a film, a thin film or a nano-film layer formed on the surface of the substrate 600. Optionally, the film may be implemented as a diamond-like carbon film (DLC film), an inorganic thin film, an organic thin film, an organic silicon protective nano-film layer, an organic silicon hard protective nano-film layer, a composite structure high-insulation hard protective nano-film layer, a high-insulation protective nano-film layer with a modulated structure, a plasma polymerized film layer, a gradient-increasing structure liquid-resistant film layer, and a gradient-decreasing structure liquid-resistant film layer, a film layer with controllable cross-linking degree, a waterproof click-through-resistant film layer, a low-adhesion and anti-corrosion film layer, a liquid-resistant film layer with a multi-layered structure, a polyurethane nano-film layer, an acrylamide nano-film layer, an anti-static and liquid- resistant nano-film layer, an epoxy nano-film layer, a high-transparency and low-chromatic nano-film layer, a high-adhesion and anti-aging nano-film layer, a silicon-containing copolymer nano-film layer and a polyimide nano-film layer, etc. Correspondingly, the coating apparatus 100 may be implemented to form any one or more of the above-mentioned films or film layers on the surface of the substrate 600 to improve the surface properties of the substrate 600, which is not limited herein.

Further, according to different types or properties, the film includes a first film layer, a second film layer, a third film layer, a fourth film layer, a fifth film layer and the like, such as a waterproof film, a diamond-like carbon film, an organic film and films with other properties, etc. For example, the first film layer and the second film layer are prepared by the coating apparatus 100 on the surface of the substrate 600. Specifically, the first film layer is firstly prepared by the coating apparatus 100 on the surface of the substrate 600, and then the second film layer is prepared by the coating apparatus 100 on the surface of the first film layer of the substrate 600. That is, the first film layer is formed on the surface of the substrate 600, and the second film layer is formed on the surface of the first film layer, so that two kinds of film layers can be formed on the surface of the substrate 600. Optionally, the second film layer is formed on the surface of the substrate 600, and the first film layer is formed on the surface of the second film layer. Optionally, further, the third film layer is formed on the surface of the first film layer or the second film layer, so that three kinds of film layers can be formed on the surface of the substrate 600. Optionally, only the fourth film layer and/or the fifth film layer are prepared on the surface of the substrate 600, which is not limit herein.

As an example, the first film layer is prepared by the coating apparatus 100 based on a gas raw material, the second film layer is prepared by the coating apparatus 100 based on a liquid raw material, and the third film layer is prepared by the coating apparatus 100 based on a liquid raw material and a gas raw material.

In some embodiments, the coating apparatus 100 includes a feeding device 110 and a device main body 120. The feeding device 110 is configured to connect with the device main body 120, and the device main body 120 is used to prepare films on the surface of the substrate 600. The feeding device 110 is used to transmit a gas raw material and/or a gas raw material gasified from a liquid to the device main body 120, and the film may be prepared on the surface of the substrate 600 by the device main body 120 based on the gas raw material. In other words, while preparing the first film layer, a gas raw material is transmitted to the device main body 120 by the feeding device 110, and the first film layer is prepared by the device main body 120. While preparing the second film layer, a gas raw material gasified from a liquid raw material is transmitted to the device main body 120 by the feeding device 110, and the second film layer is prepared. While preparing the third film layer, a gas raw material is transmitted to the device main body 120 by the feeding device 110, and a gas raw material gasified from a liquid raw material is transmitted to the device main body 120, so that the third film layer is prepared.

Further, the feeding device 110 includes a liquid feeding device 111 and a gas feeding device 112. The gas feeding device 112 is configured to communicate with the device main body 120 to transmit the gas raw material to the device main body 120, and the liquid feeding device 111 is configured to communicate with the device main body 120 to transmit the gas raw material gasified from the liquid to the device main body 120.

The present disclosure further provides a coating method, wherein a substrate 600 is placed in a device main body 120, including a step of forming a first film layer on the surface of the substrate 600, which includes:
S10. transmitting a gaseous raw material (the gas raw material) to the device main body 120; and
S20. forming the first film layer on the surface of the substrate 600 by using the device main body 120 based on the gaseous raw material.

Optionally, while forming the second film layer, the step S10 is replaced by a step S11: gasifying a liquid raw material into a gaseous raw material (the gas raw material) and transmitting the gaseous raw material to the device main body 120; and the step S20 is replaced by a step S21: forming the second film layer on the surface of the substrate 600 by using the device main body 120 based on the gaseous raw material (the gas raw material).

Optionally, while forming the third film layer, the step S10 is replaced by a step S12: transmitting a gaseous raw material (the gas raw material) to the device main body 120, and gasifying a liquid raw material (the liquid raw material) into a gaseous raw material (the gas raw material) and transmitting the gaseous raw material to the device main body 120 and mixed together with the other gaseous raw material, that is, each of the gaseous raw materials is transmitted into the same chamber of the device main body 120; and
the step S20 is replaced by a step S22: forming the third film layer on the surface of the substrate 600 by using the device main body 120 based on the gaseous raw material (the gas raw material).

Further, the coating method includes the step of continuously forming the second film layer on the surface of the first film layer of the substrate 600, which includes:
S30. gasifying a liquid raw material into a gaseous raw material (the gas raw material) and transmitting the gaseous raw material to the device main body 120; and
S40. forming the second film layer on the surface of the first film layer of the substrate 600 by using the device main body 120 based on the gaseous raw material (the gas raw material), so the first film layer and the second film layer are formed in layers on the surface of the substrate 600.

Further, the coating method includes the step of continuously forming the third film layer on the surface of the second film layer, which includes:
S50. transmitting a gaseous raw material (the gas raw material) to the device main body 120, and gasifying a liquid raw material into a gaseous raw material (the gas raw material) and transmitting the gaseous raw materials to the device main body 120; and
S60. forming the third film layer on the surface of the second film layer of the substrate 600 by using the device main body 120 based on the gaseous raw materials (the gas raw materials). Thereby, the first film layer, the second film layer and the third film layer are formed in layers on the surface of the substrate 600. Optionally, the positions of the first film layer, the second film layer and the third film layer can be interchanged arbitrarily.

In other words, by using the coating apparatus 100 to form a coating for three times, the first film layer, the third film layer and the second film layer are prepared successively on the surface of the substrate 600; or
by using the coating apparatus 100 to form a coating for three times, the second film layer, the first film layer and the third film layer are prepared successively on the surface of the substrate 600;
by using the coating apparatus 100 to form a coating for three times, the second film layer, the third film layer and the first film layer are prepared successively on the surface of the substrate 600; or
by using the coating apparatus 100 to form a coating for three times, the third film layer, the first film layer and the second film layer are prepared successively on the surface of the substrate 600; or
by using the coating apparatus 100 to form a coating for three times, the third film layer, the second film layer and the first film layer are prepared successively on the surface of the substrate 600.

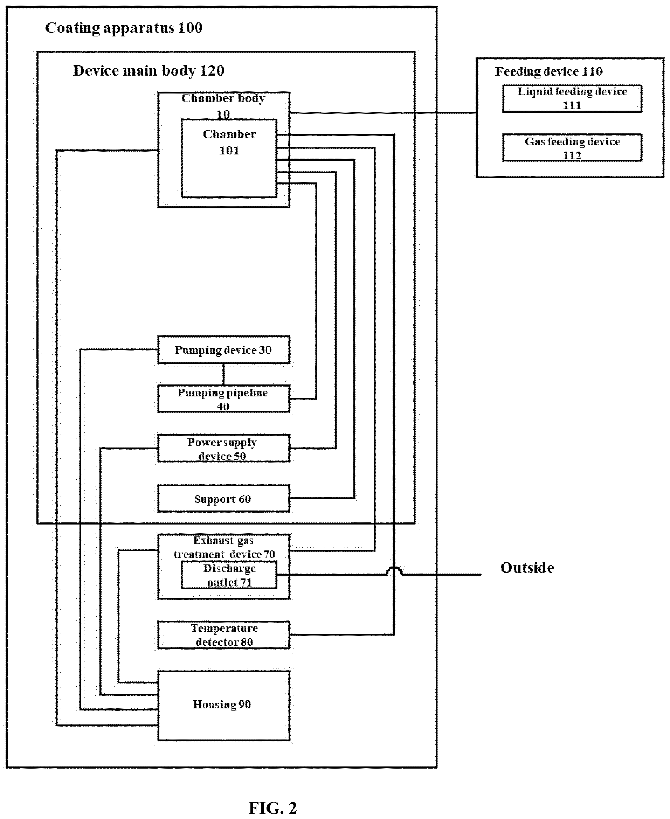

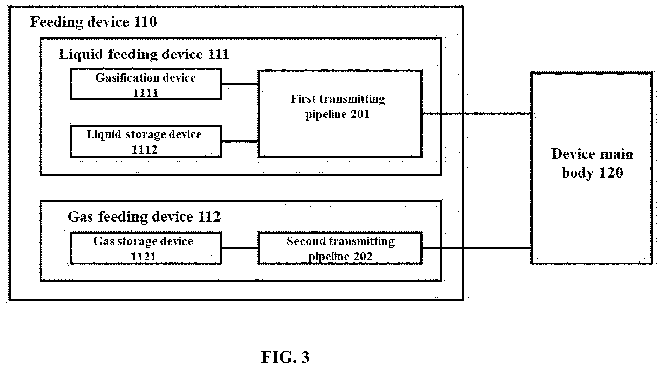

As shown in FIG. 2, the device main body 120 includes a chamber body 10, at least one pumping device 30, at least one pumping pipeline 40, a power supply device 50 and at least one support 60. The chamber body 10 is provided with a sealable chamber 101, the support 60 is configured in the chamber 101 of the chamber body 10, and the support 60 is used to support the substrate 600. As shown in FIG. 3, the liquid feeding device 111 includes at least one gasification device 1111 and at least one first transmitting pipeline 201, the at least one gasification device 1111 is used for gasifying a liquid raw material, and the liquid raw material is gasified into the gas raw material by the gasification device 1111 and transmitted to the device main body 120 via the at least one first transmitting pipeline 201. The gas feeding device 112 includes at least one second transmitting pipeline 202, and the gas raw material can be transmitted to the device main body 120 via the at least one second transmitting pipeline 202. The gas raw material may be plasma source gases of inert gases such as nitrogen, carbon tetrafluoride, helium, and argon, or may be reaction gases such as hydrogen and hydrocarbon gases, or may be assistant gases doped with elements such as N, Si, F and B. The pumping device 30 is configured to communicate with the chamber 101 of the chamber body 10 via the pumping pipeline 40, and can continuously pump the gas in the chamber 101 via the pumping pipeline 40 to control an air pressure in chamber 101. The power supply device 50 is used to provide a radio frequency and/or pulse voltage to apply on the gas in the chamber 101, so that the coating apparatus 100 can prepare a film or film layers on the surface of the substrate 600 by a chemical vapor deposition.

Optionally, the first transmitting pipeline 201 can be communicated with a storage device for storing liquid raw materials. The storage device stores the liquid raw material, and the liquid raw material can be transmitted via the first transmitting pipeline 201 under a certain pressure, and gasified into gas raw materials by the gasification device 1111 and then transmitted to the device main body 120. Optionally, the second transmitting pipeline 202 can be communicated with a storage device for storing gas raw materials, and the gas raw materials can be transmitted to the device main body 120 via the second transmitting pipeline 202 under a certain pressure.

It should be noted that, the first transmitting pipeline 201 and the second transmitting pipeline 202 can be partially shared, so as to reduce the usage amount of the pipelines and the occupied space and save the cost.

It can be understood that, by controlling the type or addition amount of the assistant gas doped with element, films or film layers with different properties or types can be prepared by the coating apparatus 100. That is, during a coating process, the substrate 600 is placed in the chamber 101 of the coating apparatus 100 for coating, and the film is prepared on the surface of the substrate 600 by controlling the addition of raw materials, and then, during next coating process, another substrate 600 is placed in the chamber 101 of the coating apparatus 100 for coating, and another film is prepared on the surface of the substrate 600 by controlling the addition of raw materials. In this way, films with different types or properties can be prepared by the same coating apparatus 100.

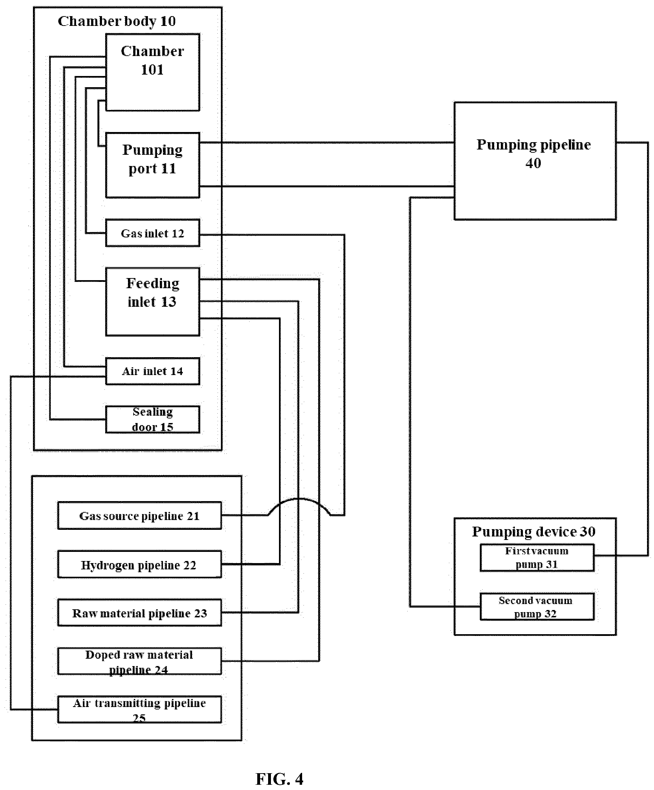

As shown in FIG. 4, further, the chamber body 10 is provided with at least one pumping port 11, at least one gas inlet 12 and at least one feeding inlet 13, which are communicated with the chamber 101. The transmitting pipeline (the first transmitting pipeline 201 or the second transmitting pipeline 202) includes at least one gas source pipeline 21, at least one hydrogen pipeline 22 and at least one reaction raw material pipeline 23. The pumping port 11 is communicated with the pumping pipeline 40 for the pumping device 30 to pump the gases in the chamber 101 via the pumping pipeline 40, and the gas inlet 12 is communicated with the gas source pipeline 21 for transmitting nitrogen, carbon tetrafluoride, helium, argon and other inert gas or plasma source gas into the chamber 101. The feeding inlet 13 is communicated with the hydrogen pipeline 22 and the reaction raw material pipeline 23. The hydrogen pipeline 22 is used for transmitting hydrogen into the chamber 101, and the reaction raw material pipeline 23 is used for transmitting hydrocarbon gas and other reaction raw materials into the chamber 101. The hydrocarbon gas may be one or more combinations of gaseous raw materials such as alkanes, olefins, and alkynes with 1-6 carbon atoms, or one or more combinations of gaseous raw materials gasified from liquid hydrocarbon raw materials with more than 6 carbon atoms. That is, the reaction raw material pipeline 23 can be used to transmit liquid reaction raw materials, and then reaction raw materials gasified from the liquid reaction raw materials can be transmitted into the chamber 101 via the feeding inlet 13. It can be understood that, the gas source pipeline 21, the hydrogen pipeline 22, the reaction raw material pipeline 23 and a doped raw material pipeline 24 can be respectively provided with an on-off valve to control the opening and closing of the pipelines, so as to control the gas to flow and stop flowing. Alternatively, the flow rate of the gas transmitted into the chamber 101 can be controlled by the on-off valve, which is not limited herein.

Further, there are two feeding inlets 13, one of the two feeding inlets 13 is coupled with the hydrogen pipeline 22 to supply only hydrogen into the chamber 101, and the other one of the two feeding inlets 13 is coupled with the reaction raw material pipeline 23 to supply a reaction raw material into the chamber 101. Optionally, there is one feeding inlet 13, and the hydrogen pipeline 22 and the reaction raw material pipeline 23 are jointly communicated with the same feeding inlet 13 for supplying hydrogen or reaction raw material into the chamber 101 via the same feeding inlet 13 respectively.

In some embodiments, the transmitting pipeline further includes a doped raw material pipeline 24. The doped raw material pipeline 24 is communicated with the feeding inlet 13 for supplying the chamber 101 with assistant gas doped with elements such as N, Si, F and B. For example, the reaction raw materials doped with Si element include, but are not limited to, silicon-containing organic compounds, including one or more combinations of organic linear siloxanes, cyclosiloxanes, alkoxysilanes, and unsaturated carbon-carbon double bond-containing siloxanes. Further, hexamethyldisiloxane, tetramethyldivinyldisiloxane, hexamethylcyclotrisiloxane and octamethylcyclotetrasiloxane can be selected. For example, the assistant gas doped with N element includes, but is not limited to, N₂ and nitrogen-containing hydrocarbons. For example, the assistant gas doped with F element includes, but is not limited to, fluorocarbon compounds, and further, is selected from carbon tetrafluoride and tetrafluoroethylene. For example, the assistant gas doped with B element includes, but is not limited to, borane with boiling point lower than 300°C under normal pressure, and further, pentaborane and hexaborane can be selected.

Optionally, the doped raw material pipeline 24 may be communicated with an additional independent feeding inlet 13 to separately fill the chamber 101 with the assistant gas doped with elements. Alternatively, the doped raw material pipeline 24 may share the same feeding inlet 13 with the hydrogen pipeline 22 or the reaction raw material pipeline 23 to fill the chamber 101 with gas.

It should be noted that when preparing the film, an atomic ratio of the content of doping elements in the film is less than 10%. In the film prepared by using the coating apparatus 100, the content of doping elements is less than 40%, and the thickness of the film is 10-800nm. It should be understood by those skilled in the art that the doping content of Si, Cu, N, F, Al, and other elements should not be too large. These doping elements and the carbon element in the film may form bonds, so that the original microstructure of the film may be destroyed, and the film growth pattern during deposition may be changed. When the content of the doping element is increased, phase separation may occur or the diamond-like structure in the film may be completely changed, so that the film will lose the properties of wear resistance and high hardness. In addition, according to different requirements of the coating process, the assistant gas doped with elements may also increase the ionization rate of the carbon-containing gas source, which is beneficial for coating.

In some embodiments, the pumping port 11 is configured in the middle of the chamber 101 of the chamber body 10, and the gas inlet 12 and the feeding inlet 13 are both configured at a side wall of the chamber 101 of the chamber body 10, so that the gas is filled from the gas inlet 12 and the feeding inlet 13 on the side wall of the chamber 101, and pumped from the pumping port 11 in the middle of the chamber 101, so as to ensure that the filled gas diffuses to the surface of each substrate 600 as uniformly as possible, and the surface of each substrate 600 is uniformly coated with the film as much as possible.

Optionally, the pumping port 11 may be configured in the middle of a bottom wall or a top wall of the chamber 101, and the pumping port 11 may also be communicated with a pumping column configured in the middle of the chamber 101. The gas inlet 12 and the feeding inlet 13 may be configured on the same side wall of the chamber 101, or may be configured on different side walls of the chamber 101 respectively. Optionally, the pumping port 11 may be configured on the side wall of the chamber 101, and the gas inlet 12 and the feeding inlet 13 may be configured at a middle of the chamber 101 or the side wall opposite to the pumping port 11, which is not limited herein.

It can be understood that the relative positions of the pumping port 11, the gas inlet 12 and the feeding inlet 13 in the chamber 101 can be preset according to the actual needs, so as to meet the needs of uniform coating of a large number of substrates as much as possible, and make the specifications uniform.

In order to prevent the physical and chemical reaction of each raw material due to doping before transmitting, each raw material can be stored independently, and each raw material can be transmitted via the independent transmitting pipeline. Alternatively, for some raw materials that are not easily reacted with each other when doped with each other, these raw materials that are not easily reacted with each other can be transmitted via the same transmitting pipeline.

Further, the liquid feeding device 111 includes at least one liquid storage device 1112, and the liquid storage device 1112 is used for storing liquid raw materials and transmitting the liquid raw materials to the first transmitting pipeline 201. The gas feeding device 112 further includes at least one gas storage device 1121, and the gas storage device 1121 is used for storing gas raw materials and transmitting the gas raw materials to the chamber 101 via the second transmitting pipeline 202.

In some embodiments, the gas storage device 1121 includes a container for storing plasma gas source, a container for storing hydrogen gas, and a container for storing gaseous reaction raw materials, which are respectively communicated with the plasma gas source pipeline 21, the hydrogen pipeline 22 and the reaction raw material pipeline 23. Further, the liquid storage device 1112 includes a container for storing liquid reaction raw materials, which is communicated with the reaction raw material pipeline 23. The gasification device 1111 is configured to connect with the reaction raw material pipeline 23 for gasifying the reaction raw material transmitted from the reaction raw material pipeline 23. Of course, the liquid storage device 1112 may also include a container for storing liquid hydrogen or other liquid raw materials, which is not limited herein. That is to say, the raw materials stored in the gas storage device 1121 and the liquid storage device 1112 respectively are the raw materials for preparing organic films or inorganic films.

For example, the gasification device 1111 is implemented as a heating device for gasifying a liquid raw material into a gas raw material by heating or increasing the temperature. Alternatively, the gasification device 1111 is implemented as a pressure reduction device for reducing the pressure of the liquid raw material and gasifying it into the gas raw material.

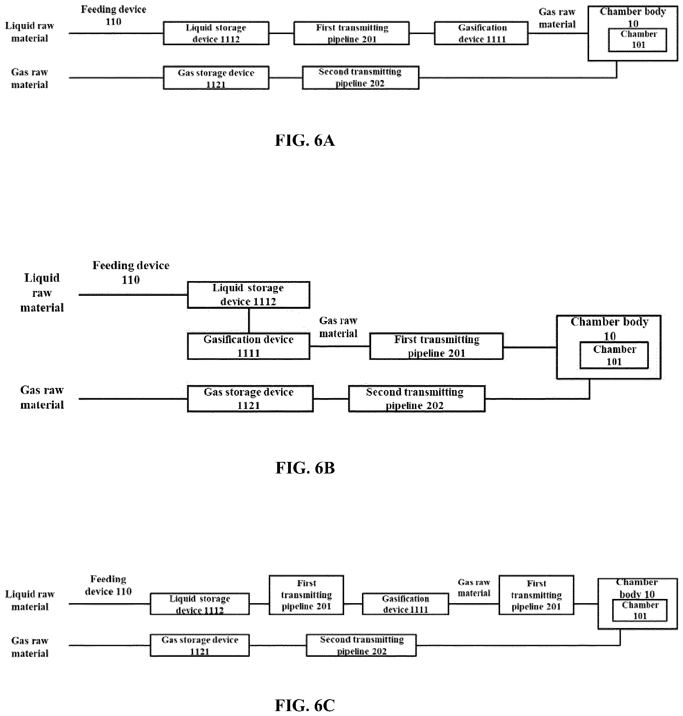

More specifically, as shown in FIG. 6B, the gasification device 1111 can be connected between the liquid storage device 1112 and the first transmitting pipeline 201, so that the liquid raw material stored in the liquid storage device 1112 is gasified by the gasification device 1111 to form the gas raw material, and the gas raw material transmitted to the chamber 101 via the first transmitting pipeline 201. That is, the first transmitting pipeline 201 only is used for transmitting gas raw materials without transmitting liquid raw materials, so as to prevent liquid raw materials from remaining in the first transmitting pipeline 201, so as to prevent blockage, or the phenomenon of freezing in the first transmitting pipeline 201 in a cold environment.

As shown in FIG. 6A, alternatively, the gasification device 1111 is configured between the chamber body 10 and the first transmitting pipeline 201, so that the liquid raw material stored in the liquid storage device 1112 is transmitted via the first transmitting pipeline 201, and gasified by the gasification device 1111 to form the gas raw material which is transmitted into the chamber 101. The first transmitting pipeline 201 can transmit the liquid raw materials which are not easy to block the first transmitting pipeline 201, so that the material requirements for the first transmitting pipeline 201 may be less or the cost may be reduced.

As shown in FIG. 6C, alternatively, the gasification device 1111 is configured between the two ends of the first transmitting pipeline, such as the middle position, so that the liquid raw materials can be gasified into the gas raw materials and the gas raw materials can be transmitted into the chamber 101, and the gasification device 1111 is not directly connected with the liquid storage device 1112 or the chamber body 10, so the requirements for installation process are low, and it is convenient for independent installation and disassembly, which is not limited herein.

Further, in the coating method, while preparing the first film layer, the step S10 includes the steps:
S101. storing the gas raw material in the gas storage device 112; and
S102. transmitting the gas raw material to the chamber 101 of the chamber body 10 of the device main body 120.

Further, while preparing the second film layer, the step S11 includes the steps:
S111. storing the liquid raw material in the liquid storage device 1112; and
S112. gasifying the liquid raw material into the gas raw material and transmitting the gas raw material to the chamber 101 of the chamber body 10 of the device main body 120.

Further, while preparing the third film layer, the step S12 includes the steps:
S121. storing the liquid raw material in the liquid storage device 1112, and storing the gas raw material in a gas storage device 112;
S122. transmitting the gas raw material to the chamber 101; and
S123. gasifying the liquid raw material into the gas raw material and transmitting the gas raw material to the chamber 101.

Optionally, the step S122 is executed after the step S123, or the step S122 and the step S123 are executed simultaneously.

Further, the liquid raw materials can be gasified into the gas raw materials by heating or depressurizing.

It should be pointed out that the element species of the gas raw material and the liquid raw material may be same or different, that is, the gas raw material gasified from the liquid raw material and the gas raw material stored in the gas storage device 112 may be same or different, which is not limited herein. Preferably, the pumping device 30 includes at least one first vacuum pump 31 and at least one second vacuum pump 32, the first vacuum pump 31 and the second vacuum pump 32 are respectively communicated with the pumping port 11 via the pumping pipeline 40, and the second vacuum pump 32, as a fore pump of the first vacuum pump 31, cooperates with the first vacuum pump 31 to perform negative pressure operation on the chamber 101 via the pumping pipeline 40, such as vacuumizing and maintaining the air pressure in the chamber 101 within a preset range. Further, gases in the chamber 101 are pumped out to be close to a vacuum state. For example, the air pressure in the chamber 101 is reduced to below 0.01Pa, or even below 0.001Pa. During the coating process, the pumping device 30 is used to continuously pump out the gases in the chamber 101 via the pumping pipeline 40 to maintain the concentration of the gas in the chamber 101 within a certain range. For example, the air pressure in the chamber 101 is maintained between 0.01 and 100 Pa.

Before coating by the coating apparatus 100, the staff opens the chamber 101 of the chamber body 10, the substrate 600 is placed on the support 60, and the support 60 is configured in the chamber 101. Then, the staff seals and closes the chamber 101 of the chamber body 10, and then opens the coating apparatus 100 for coating.

Further, the present disclosure also provides a coating method for the device main body 120 of the coating apparatus 100, including the steps:

S01. Generating a negative pressure in the chamber 101, such as vacuumizing, during coating. The gas in the chamber 101 is pumped via the pumping device 30 to control the air pressure in the chamber 101 within a preset range, so as to minimize the influence of residual gas in the chamber 101 on the coating quality, until the air pressure in the chamber 101 reaches a preset air pressure range.

S02. Performing surface etching treatment or surface cleaning and activation on the surface of the substrate 600. Specifically, gas is continuously introduced into the chamber 101 via the gas source pipeline 21 for performing surface etching treatment on the substrate. Preferably, argon gas or helium gas is introduced into the chamber 101 via the gas source pipeline 21. A flow rate of the gas introduced is approximately 10 sccm to 1000 sccm, preferably 80 or 100 sccm. At the same time, the pumping device 30 is used for continuously pumping a certain amount of gas in the chamber 101 and maintaining the air pressure in the chamber 101 within 0.01-100Pa, preferably 8 Pa or 10Pa or 100 Pa. At the same time, the power supply device 50 provides a pulse voltage to the gas in the chamber 101 to clean and activate the surface of the substrate 600, so that the surface of the substrate 600 can be etched. Optionally, the power supply device 50 provides a high-voltage pulse bias of -100V to -5000V, a duty ratio of 1% to 90%, and a power supply time within 1-60 minutes (the power supply time is the time for cleaning and activating the surface of the substrate 600 in step S02). Optionally, the supply voltage of the power supply device 50 is - 3000V, the duty cycle is 20% or 30%, the frequency is 10 kHz or 40 kHz, and the power supply time is 5, 10, 20, or 30 minutes, etc.

Optionally, when the step S02 is completed, the gas source pipeline 21 is closed to stop filling the chamber 101 with the gas. Specifically, the gas source pipeline 21 has the on-off valve, and the on-off valve is used to control the switch of the gas source pipeline 21 to open or close the gas source pipeline 21.

Optionally, when the step S02 is completed, continually transmit the gas into the chamber 101 via the gas source pipeline 21, so that the film is prepared on the surface of the substrate 600 by subsequent plasma chemical vapor deposition. Optionally, the flow rate of the gas introduced into the chamber 101 can be adaptively changed.

It should be noted that, in the process of cleaning and activating the surface of the substrate 600, the flow rate of the gas introduced into the chamber 101 via the gas source pipeline 21 can be preset within a reasonable range to prevent the flow rate of the gas charged into the chamber 101 from being too high or too low, which will affect the ionization effect on the surface of the substrate 600. The pulse voltage provided by the power supply device 50 is preset within a reasonable range, so as to prevent the voltage from being too low to achieve a good cleaning and activation effect on the surface of the substrate 600, or to prevent the voltage from being too high, which may damage the substrate 600. The power supply time of the power supply device 50 can be preset within a reasonable range to prevent the power supply time from being too short to achieve a good cleaning and activation effect on the surface of the substrate 600, or to prevent the power supply time from being too long, which may extend the cycle of the coating process and result in unnecessary waste.

S03. Forming a coating on the surface of the substrate 600. Specifically, the gas is introduced into the chamber 101 via the gas source pipeline 21, hydrogen is introduced into the chamber 101 via the hydrogen pipeline 22, and reaction raw materials such as hydrocarbon gas or hydrocarbon gas after gasification are introduced into the chamber 101 via the reaction raw material pipeline 23, or further, the assistant gas doped with elements are introduced into the chamber 101 via the doped raw material pipeline 24. Preferably, the gas flow rate introduced into the chamber 101 is 10-200 sccm, the flow rate of hydrogen gas is 0-100 sccm, the flow rate of reaction raw materials such as hydrocarbon gas is 50-1000 sccm, or the flow rate of assistant gas doped with elements is 0-100 sccm. At the same time, the pumping device 30 is used for continuously pumping a certain amount of gas in the chamber 101 and maintaining the air pressure in the chamber 101 within 0.01-100 Pa, for example, 8Pa or 10Pa or 100Pa. At the same time, the film is prepared on the surface of the substrate 600 by using the power supply device 50 to provide a radio frequency electric field and/or a high-voltage pulse bias voltage to assist plasma chemical vapor deposition. The power of the radio frequency voltage provided by the power supply device 50 is 10-800W, or the voltage for providing a pulse bias voltage is -100V to -5000V, and the duty cycle is 10%-80%, the power supply time of the power supply device 50 is 5-300 minutes, that is, in the step S03, the time for coating the substrate 600 is approximately 5-300 minutes.

It should be understood that, in the step S03, the voltage or power of the power supply device 50 can be preset. Under the voltage provided by the power supply device 50, all the gases in the chamber 101 can basically be ionized into plasma, which makes a plasma environment formed in the chamber 101, so that the coating apparatus 100 can be used to prepare the film on the surface of the substrate 600 by the chemical vapor deposition.

In the step S03, specifically, the power supply device 50 can provide the radio frequency and/or the high-voltage pulse bias voltage to the gas in the chamber 101. The power supply device 50 discharges the gas in the chamber 101 by providing the radio frequency electric field, so that the chamber 101 is in a plasma environment and the reaction gas raw material is in a high energy state. A strong voltage in the high-voltage pulse bias voltage provided by the power supply device 50 generates a strong electric field in the chamber 101, so that active particles in the high-energy state are accelerated to deposit on the surface of the substrate 600 under the strong electric field, and an amorphous carbon network structure is formed. The power supply device 50 provides an empty voltage or a low voltage state in the high-voltage pulse bias voltage for free relaxation of the amorphous carbon network structure deposited on the surface of the substrate 600, and under the action of thermodynamics, the carbon structure is transformed into a stable phase-bent graphene sheet structure, and is embedded in the amorphous carbon network, so that the film is formed on the surface of the substrate 600.

It should be noted that, in the step S03, the gas source pipeline 21 can be closed to stop introducing the gas into the chamber 101, or the flow rate of the gas introduced into the chamber 101 via the gas source pipeline 21 can be preset within a reasonable range. The hydrogen pipeline 22 can be closed so as not to introduce hydrogen into the chamber 101, or so as to stop introducing hydrogen into the chamber 101, or the flow rate of the hydrogen introduced into the chamber 101 via the hydrogen pipeline 22 can be preset within a reasonable range. The reaction raw material pipeline 23 can be switched on and off, and the gas flow rate of the reaction raw material introduced into the chamber 101 via the reaction raw material pipeline 23 can be preset within a reasonable range. The doped raw material pipeline 24 can be closed, so as not to introduce the assistant gas doped with elements into the chamber 101, or so as to stop introducing the assistant gas doped with elements into the chamber 101, or the flow rate of the assistant gas doped with elements introduced into the chamber 101 via the doped raw material pipeline 24 can be preset within a reasonable range.

It should be understood that, the atomic ratio in the film is determined by the ratio of the flow rate of the gas to be ionized introduced into the chamber 101, such as nitrogen or helium, the hydrogen, the reaction raw material gas or the assistant gas doped with elements, which affects the quality of the film. By presetting parameters such as the power level or voltage level of the radio frequency and/or pulse bias provided by the power supply device 50, it is possible to adjust and control related parameters such as temperature, ionization rate or deposition rate during the coating process, or by presetting the power supply time of the power supply device 50 to prevent the phenomenon of thin film and poor hardness due to too short coating time, or to prevent the film from being thick to affect the transparency due to long coating time.

That is to say, in the step S03, without filling the chamber 101 with hydrogen at different flow rates, the DLC film containing varying contents of hydrogen can be prepared by filling the chamber 101 with a certain amount of hydrogen. It can be understood that, the DLC film with higher hydrogen content has higher lubricity and transparency than the DLC film with lower hydrogen content. In the step S03, a certain amount of hydrogen is filled into the chamber 101, which is conducive to the formation of SP3 bonds during the coating process, which can improve the hardness of the film to a certain extent. However, with the increasing of the hydrogen content, the hardness of the film gradually decreases, so according to different coating requirements, in the step S03, the chamber 101 can be selectively filled with a preset amount of hydrogen via the hydrogen pipeline 22.

Correspondingly, in the step S03, the chamber 101 can be selectively filled with a certain amount of the reaction raw material doped with specified element via the doped raw material pipeline 25. For example, a reaction raw material doped with fluorine is filled into the chamber, so that the film has a good hydrophobic effect and transparency, but when the content of fluorine atoms exceeds 20%, the hardness of the film will be significantly reduced (lower than the Mohs hardness of 4H).

S04. When the coating time of step S03 ends, the on-off valves of the gas source pipeline 21, the hydrogen pipeline 22, the reaction raw material pipeline 23 and the doped raw material pipeline 24 of the transmitting pipeline (i.e., the first transmitting pipeline 201 and the second transmitting pipeline 202) are closed, and the power supply device 50 and the pumping device 30 are closed. Further, the transmitting pipeline further includes an air transmitting pipeline 25, and the chamber body 10 further has at least one air inlet 14 communicating with the chamber 101. The air transmitting pipeline 25 is communicated with the air inlet 14 of the chamber 101, and the air transmitting pipeline 25 is used to fill the chamber 101 with air to make the chamber 101 in an ordinary pressure state. That is, a certain amount of air is filled into the chamber 101 via the air transmitting pipeline 25 to make the chamber 101 return to the ordinary pressure state, so that the staff can open the chamber 101 and take out the substrate 600, at this point, the coating process is over. During the entire coating process, the coating apparatus 100 has a good process controllability in the process of preparing films, which is conducive to the rapid preparation of target films.

It can be seen that, during the entire coating process, the chamber 101 can always be in a normal temperature or a low temperature state, and the coating apparatus 100 can be used to complete the coating at a normal temperature or a low temperature, so the coating time is short, which is conducive to saving cost. That is to say, the coating apparatus 100 can be used to coat some substrates that are not resistant to high temperature, so that the substrates are not easily damaged during the coating process. Compared with the method of coating by the physical vapor deposition such as magnetron sputtering, the coating apparatus 100 of the present disclosure can always keep the substrate 600 in a relatively low temperature state during the entire coating process without excessively increasing the temperature of the substrate 600.

In some embodiments, the coating apparatus 100 further includes an exhaust gas treatment device 70. The exhaust gas treatment device 70 is communicated with the pumping pipeline 40, and the exhaust gas treatment device 70 is used for treating and discharging the exhaust gas pumped via the pumping device 30. The exhaust gas treatment device 70 can be used for recycling or non-polluting treatment of the gases such as nitrogen or helium, reaction raw materials such as hydrogen and hydrocarbon gases, or assistant gases doped with elements, and then discharging them to the outside to prevent pollution to the environment, thereby achieving recycling.

Further, the first vacuum pump 31 is implemented as a molecular pump, and the second vacuum pump 32 includes a Roots pump and a dry pump. The pumping port 11 of the chamber 101, the first vacuum pump 31, the Roots pump, the dry pump and the exhaust gas treatment device 70 are all communicated by the pumping pipeline 40. Specifically, the gas in the chamber 101 can be pumped out by the dry pump, the Roots pump and the molecular pump in sequence. That is, the second vacuum pump 32 serves as a pre-stage pump to pump the chamber 101 firstly, the first vacuum pump 31 serves as a post-stage pump to further pump the chamber 101, and the gas pumped out from the chamber 101 can be treated or recycled by the exhaust gas treatment device 70 and then discharged to the outside.

It should be pointed out that, the second vacuum pump 32 includes at least one mechanical pump, which serves as a pre-stage pump for pumping the chamber 101. Molecular pumps serve as a secondary pump group to further pump the chamber, so that the air pressure in the chamber 101 can be maintained in a low range as much as possible.

In this embodiment, the model parameter of the pipeline between the chamber 101 and the Roots pump is DN100, and the interface is IOS100. The model parameter of the pipeline between the Roots pump and the dry pump is DN63, and the interface is not limited. The model parameter of the pipeline of the exhaust gas treatment device 70 is NB32, and the interface is not limited. It should be understood by those skilled in the art that the models and specifications of the pipeline between the chamber 101 and the Roots pump, the pipeline between the Roots pump and the dry pump, and the pipeline of the exhaust gas treatment device 70 can be preset according to actual coating requirements, which are not limited herein.

Further, the power supply device 50 includes a radio frequency power supply 51 and a pulse power supply 52. The radio frequency power supply 51 can be used to generate a radio frequency electric field in the chamber 101 of the chamber body 10 by directly applying the electrode plate, so as to apply on the gas in the chamber 101, and the pulse power supply 52 is used to provide a high-voltage pulse bias to apply on the gas in the chamber 101. Specifically, during coating, the radio frequency power supply 51 is used to discharge the gas in the chamber 101 by providing the radio frequency electric field, so that the chamber 101 is in a plasma environment and the reaction gas raw material is in a high-energy state. The pulse power supply 52 can be used to generate a strong electric field in the chamber 101 by providing a strong voltage in the high-voltage pulse bias voltage, so that active particles (i.e., positive ions) in a high-energy state directionally accelerate the deposition on the surface of the substrate 600 under the strong electric field, and an amorphous carbon network structure is formed. The power supply device 50 provides an empty voltage or a low voltage state in the high-voltage pulse bias voltage for free relaxation of the amorphous carbon network structure deposited on the surface of the substrate 600, and under the action of thermodynamics, the carbon structure is transformed into a stable phase--bent graphene sheet structure, and is embedded in the amorphous carbon network, so that the film is formed on the surface of the substrate 600.

The radio frequency power supply 51 can also be used as a plasma supporting power supply, and the radio frequency power supply 51 includes a radio frequency power source, an impedance matcher and an impedance power meter. The radio frequency power supply 51 is configured in the chamber body 10 to provide a radio frequency electric field to apply on the gas in the chamber 101. The radio frequency power supply 51 can be used to provide a radio frequency power of 13.56MHz.

Further, the radio frequency power supply 51 can be used to generate the radio frequency electric field in the chamber 101 of the chamber body 10 by directly applying the radio frequency voltage on an electrode plate configured in the chamber body 10, so that the radio frequency electric field applies on the gas in the chamber 101 to satisfy the coating requirements. Optionally, the radio frequency power supply 51 can also be implemented to generate an alternating magnetic field in the chamber 101 as an ICP by an inductive coupling of a coil, so as to ensure the full and uniform ionization of the gas in the chamber 101 under the rapidly changing magnetic field, and to satisfy the coating requirements of the coating apparatus 100, which is not limited herein.

Further, when preparing films with different properties or types, the radio frequency power supply 51 and the pulse power supply 52 of the power supply device 50 are selectively turned on respectively. In other words, the device main body 120 can be used to prepare the above-mentioned film by simultaneously supplying a voltage from the radio frequency power supply 51 and the pulse power supply 52 to the gas raw material in the chamber 101. Optionally, the device main body 120 can also be used to prepare other types of films. For example, when preparing a film, the radio frequency power supply 51 of the power supply device 50 is turned on, and the pulse power supply 52 is turned off, so as to provide only the radio frequency electric field to apply on the gas raw material in the chamber 101, thereby the film is prepared. Alternatively, when preparing another film, the pulse power supply 52 of the power supply device 50 is turned on, and the radio frequency power supply 51 is turned off, so as to provide only the pulse voltage to apply on the gas raw material in the chamber 101, thereby another film is prepared.

For example, when preparing the first film layer, the radio frequency power supply 51 is used to provide the radio frequency electric field to apply on the gas raw material in the chamber 101, and the first film layer is formed on the surface of a substrate 600. When preparing the second film layer, the pulse power supply 52 is used to provide the pulse voltage to apply on the gas raw material in the chamber 101, and the second film layer is formed on the surface of a substrate 600. When preparing the third film layer, the radio frequency power supply 51 is used to provide the radio frequency electric field and the pulse power supply 52 is used to provide the pulse voltage to apply on the gas raw material in the chamber 101, and the third film layer is formed on the surface of a substrate 600. Optionally, when preparing the first film layer, the pulse power supply 52 is used to provide the pulse voltage to apply on the gas raw material in the chamber 101, and the first film layer is formed on the surface of the substrate 600. Optionally, when preparing the first film layer, the radio frequency power supply 51 is used to provide the radio frequency electric field and the pulse power supply 52 is used to provide the pulse voltage to apply on the gas raw material in the chamber 101, and the first film layer is formed on the surface of a substrate 600.

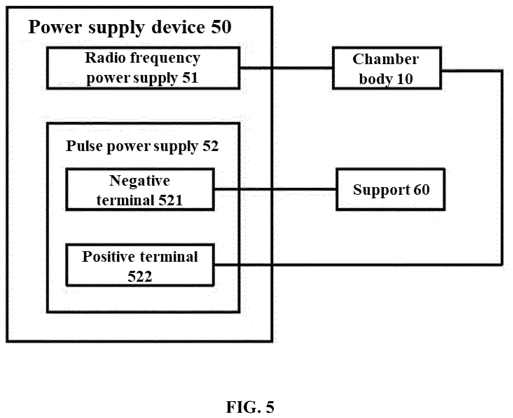

As shown in FIG. 5, the pulse power supply 52 is implemented as a unidirectional negative pulse power supply, and the pulse power supply 52 has a negative terminal 521 and a positive terminal 522. The negative terminal 521 is electrically coupled with the support 60 and provides a negative pressure, and the positive terminal 522 is electrically coupled with the chamber body 10 and is grounded at a positive or zero potential. The support 60 and the chamber body 10 are made of conductive materials such as metal materials, and the support 60 is insulated from the chamber body 10. That is to say, during the coating process, the entire support 60 is a negative electrode and has a negative pressure, the entire chamber body 10 is grounded as a positive electrode, and the support 60 is insulated from the chamber body 10, so that the entire chamber 101 is in a strong electric field. Thereby, the substrate 600 is placed on the support 60, and active particles in a high-energy state are accelerated to deposit on the surface of the substrate 600 under the strong electric field, and films are formed.

It should be noted that, the pulse power supply 52 ionizes the gas in the chamber 101 by a glow discharge effect, and at the same time has the effect of directional traction and acceleration on the positive ions in the chamber 101, so that the positive ions are accelerated to deposit on the surface of the substrate 600 with a bombardment effect, and the dense and high-hardness film is formed on the surface of the substrate 600.

It can be seen that, since the entire support 60 is a negative terminal, the support 60 can provide as much space as possible for installing and arranging a large number of substrates 600, and all the substrates 600 on the support 60 can be coated during one coating process, so as to achieve a large-area coating and mass production of the film.

It should be noted that, in the step S03, the radio frequency power supply 51 and the pulse power supply 52 are used to provide a voltage to apply on the gas in the chamber 101, and the low-power radio frequency discharge provided by the radio frequency power supply 51 maintains the plasma environment in the chamber 101 and suppresses the arc discharge during the high-voltage discharge process (Since arc discharge is a form of discharge that is further enhanced by glow discharge, the instantaneous current can reach tens or even hundreds of amperes, and these high currents passing through the surface of the substrate will damage the substrate. Therefore, in order to ensure the safety of the substrate 600, it is necessary to suppress the arc discharge during the coating process). At the same time, the pulse power supply 52 increases the energy of positive ions reaching the surface of the substrate 600 so as to prepare the dense and transparent film.

It should be pointed out that, the power supply device 50 in some embodiments includes the radio frequency power supply 51 and the pulse power supply 52, so as to satisfy the coating requirements. In an optional situation, according to different coating requirements, the power supply device 50 can also include only one of the radio frequency power supply 51 and the pulse power supply 52, which can also satisfy the coating requirements. It should be understood by those skilled in the art that, the power supply device 50 can also be implemented as a microwave power supply and other power supply to satisfy the coating requirements, which is not limited herein.

It should be noted that, according to the coating requirements of different substrates, the radio frequency voltage power and power supply time of the radio frequency power supply 51 can be adjusted and preset. For example, the power of the radio frequency voltage of the radio frequency power supply 51 is 10-800W. Correspondingly, the pulse bias voltage, pulse frequency, duty cycle and power supply time provided by the pulse power supply 52 can be adjusted and preset. For example, the pulse bias voltage provided by the pulse power supply 52 is -100V to -5000V, the pulse frequency is 20-300KHz, and the duty cycle is 10%-80%, which is not limited herein.

Since the value of the negative pressure bias provided by the pulse power supply 52 is directly related to the ionization rate of the gas in the chamber 101 and the migration ability of positive ions to the surface of the substrate 600, higher negative voltage provided by the pulse power supply 52 makes higher energy of the positive ions, so that film with higher hardness is formed. However, it should be noted that the higher the energy of the positive ions, the higher the bombardment energy of the surface of the substrate 600. On the micro scale, bombardment craters will be generated on the surface of the substrate 600, and at the same time, the increase of the temperature of the surface of the substrate 600 will be accelerated. Therefore, the negative voltage of the pulse power supply 52 should not be too high, so as to prevent the temperature of the surface of the substrate 600 from being excessively increased to damage the substrate 600. In addition, with higher pulse frequency of the pulse power supply 52, the continuous accumulation of charges on the surface of the insulating portion of the substrate 600 can be avoided, so as to suppress the large arc phenomenon and increase the deposition thickness limit of the film.

Further, the coating apparatus 100 includes a temperature detector 80, and the temperature detector 80 is used to detect and feed back the reaction temperature in the chamber 101 during the coating process. For example, prompting the staff in the form of screen display or voice alarm further ensures that the temperature of the substrate is not easy to be too high. Specifically, the temperature detector 80 has a thermocouple, and the thermocouple is disposed on the support 60 at an equivalent position of the substrate 600, and the thermocouple can be used to detect the reaction temperature inside the chamber 101. Therefore, according to the reaction temperature detected by the thermocouple, the temperature detector 80 can be used to determine whether the temperature threshold of the substrate 600 is exceeded, if it is exceeded, the temperature detector 80 feeds back the abnormal signal of excessive temperature to remind the staff to deal with or suspend the coating apparatus 100 in time. And if it is not exceeded, the reaction temperature on the surface of the substrate 600 is normal, so the substrate 600 is safe.

Alternatively, the support 60 is implemented as a metal plate of multi-layer structure, and a certain amount of the substrate 600 can be placed in each layer. The support 60 has at least one insulating part 61, and the insulating part 61 is configured between the support 60 and the wall of the chamber 101, so that the support 60 is insulated from the chamber body 10. Alternatively, the insulating part 61 is made of insulating materials such as polytetrafluoroethylene.

In some embodiments, the chamber 101 is not connected with the pulse power supply 52, the support 60 is implemented as a multi-layered metal plate, and adjacent layers are insulated from each other. The positive terminal 522 and the negative terminal 521 of the pulse power supply 52 are electrically coupled with each layer of metal plates of the support 60 respectively, so that the adjacent metal plates of the support 60 are mutually positive and negative. Further, the pulse power supply 52 can be implemented as a positive and negative bidirectional pulse power supply, each metal plate of the support 60 forms a positive electrode or a negative electrode alternately, and adjacent metal plates are always mutually positive and negative, so that the substrate 600 can be placed on the metal plates of each layer, and the film is formed on the surfaces of the substrates 600 on all the metal plates, thus the quality of the film is even better.

Optionally, the pulse power supply 52 can also be implemented as a symmetrical bidirectional pulse power supply, that is, the positive pressure and the negative pressure provided by the pulse power supply 52 have the same value. Optionally, the pulse power supply 52 is implemented as an asymmetric bidirectional pulse power supply, and the value of the negative pressure provided by the pulse power supply 52 is greater than the value of the positive pressure to ensure the quality of the film, which is not limited herein.

It should be noted that, the shape and structure of the support 60 are not limited, and within the volume of the chamber 101, the shape, the size and the quantity of the support 60 can be adjusted adaptively. Preferably, the size of the chamber body 10 is: 800mm×638mm×740mm, and the material is stainless steel. Further, the chamber body 10 has an openable and closable sealing door 15 for staff to open or seal the chamber 101 to place or take out the substrate 600 and the chamber 101.

Further, the support 60 is detachably supported on the chamber 101, so that the support 60 can be taken out from the chamber 101, and the staff can pre-install the substrate 600 on the support 60 outside the chamber 101, and then place the support 60 in the chamber 101. When a first coating process is finished, the staff can take out all the substrates 600 by taking out the support 60, so as to minimize the damage to the substrates 600 and ensure the safety of the substrates 600, thus cleaning the chamber 101 and the support 60 is facilitated. In addition, the support 60 can be reused, that is, during a second coating, the support 60 can be used to place another batch of the substrates 600 again, and then be placed in the chamber 101 to achieve coating again, which is beneficial to mass production.

For example, the parameters of the coating apparatus 100 during the coating process are as follows: air inflow: Ar/N₂/H₂/CH₄: 50-500 sccm, C₂H₂/O₂: 10-200 sccm; the vacuum degree of the chamber 101 before the coating (the stage of the step S02): less than 2×10⁻³Pa; the vacuum degree of the coating chamber 101 during the coating (the stage of the step S03): 0.1~20Pa; coating voltage: -300~-3500V, duty cycle: 5-100%, frequency: 20~360KHz; coating time: 0.1-5 hrs, thus the thickness of the film is less than 50 nanometers, which is only an example and does not limit the present disclosure.

Further, the coating apparatus 100 further includes a housing 90, and the chamber body 10, the feeding device 110, the transmitting pipeline (the first transmitting pipeline 201 or the second transmitting pipeline 202), the pumping device 30, the pumping pipeline 40, the power supply device 50, the exhaust gas treatment device 70, and the temperature detector 80 can be configured on the housing 90. Further, the housing 90 has a control panel, and the control panel is used for the staff to control the switch or working state of the pumping device 30 and the power supply device 50, and to display the process and related parameters of the coating process of the coating apparatus 100.

Further, the present disclosure also provides the film prepared by the coating apparatus 100 and formed on the surface of the substrate 600. It can be understood that, the film may include one or more layers formed on the surface of the substrate 600 by the coating apparatus 100 for one or more times.

Further, the present disclosure also provides a method for preparing multiple layers of films of different types or properties on the surface of a same substrate by the coating apparatus 100.

S10. placing the substrate 600 in the chamber 101 of the coating apparatus 100 to prepare the first film on the surface of the substrate 600 by the coating apparatus 100 through the above coating method once.

S20. using the above coating method again to prepare the second film on the outer side of the first film on the surface of the substrate 600 by the coating apparatus 100, so as to realize the preparation of two layers of films on the surface of the substrate 600 by the same coating apparatus 100.

That is, in the step S10, a layer of the first film is formed on the surface of the substrate 600 by the coating apparatus 100, and after the step S10, by setting the parameters of the coating apparatus 100 and controlling the type or amount of the reaction raw materials re-added into the chamber 101, in the step S20, a second coating is performed on the substrate 600, so that the second film is deposited on the outer side of the first film of the substrate 600.

Further, after the step S10 and before the step 20, the coating method further includes a step S30, which includes: cleaning the chamber 101 of the coating apparatus 100, so that the residual gas in the chamber 101 after the coating in step S10 is cleaned, so as to prevent interference with the coating process in step S20 or affect the property of the second film. Optionally, in the cleaning method of step S30, the chamber 101 is filled with air to discharge the residual gas in the chamber 11.

Certainly, the method for preparing the multi-layered film on the surface of the same substrate by the coating apparatus 100 further includes step S40: preparing the third film on the outer side of the second film on the surface of the substrate 600 by the coating apparatus 100 again through the above coating method, so that three layers of films can be formed on the surface of the substrate 600 by the same coating apparatus 100. It can be understood that, the same coating apparatus 100 can also be used to continuously prepare four layers, five layers or even more layers of films on the surface of the substrate 600.

It should be noted that, by setting the parameters of the coating apparatus 100 for each coating and controlling the type or amount of the reaction raw materials added, the first film, the second film and the third film may have the same type or property. Or two of the first film, the second film and the third film have the same type or property and the other one has a different type or property. Or the first film, the second film and the third film have different types or properties, which are not limited herein.

Those skilled in the art will appreciate that, the embodiments of the present disclosure shown in the foregoing description and the accompanying drawings are by way of example only and are not intended to limit the present disclosure. The advantages of the present disclosure have been completely and effectively realized. The functionality and structural principles of the present disclosure have been shown and illustrated in the embodiments, and embodiments of the disclosure may be varied or modified without departing from the principles described herein.

## Claims

1. A coating apparatus for forming a coating on a surface of a substrate, comprising:
a feeding device; and
a device main body, wherein the feeding device is configured to connect with the device main body, the feeding device comprises a gas feeding device and a liquid feeding device, the gas feeding device is configured to communicate with the device main body to transmit a gas raw material to the device main body, the liquid feeding device is configured to communicate with the device main body to transmit a gas raw material gasified from a liquid to the device main body, and a film is prepared by the device main body based on the gas raw material.

2. The coating apparatus according to claim 1, wherein the liquid feeding device comprises at least one gasification device and at least one first transmitting pipeline, the at least one gasification device is used for gasifying a liquid raw material, and the liquid raw material is gasified into the gas raw material by the gasification device and transmitted to the device main body via the at least one first transmitting pipeline.

3. The coating apparatus according to claim 2, wherein the liquid feeding device further comprises at least one liquid storage device, and the at least one liquid storage device is used for storing the liquid raw material and is configured to communicate with the device main body via the at least one first transmitting pipeline, so that the liquid raw material can be gasified into the gas raw material by the at least one gasification device and transmitted to the device main body.

4. The coating apparatus according to claim 3, wherein the gasification device is configured between the first transmitting pipeline and the liquid storage device.

5. The coating apparatus according to claim 3, wherein the gasification device is configured between the first transmitting pipeline and the device main body.

6. The coating apparatus according to claim 3, wherein the gasification device is configured between two ends of the first transmitting pipeline.

7. The coating apparatus according to claim 3, wherein the gasification device is implemented as a heating device or a pressure reducing device.

8. The coating apparatus according to any one of claim 1 to claim 7, wherein the gas feeding device comprises at least one second transmitting pipeline, the at least one second transmitting pipeline is configured to communicate with the device main body, and the gas raw material can be transmitted to the device main body via the at least one second transmitting pipeline.

9. The coating apparatus according to claim 8, wherein the gas feeding device comprises at least one gas storage device, and the at least one gas storage device is used for storing the gas raw material and is configured to communicate with the device main body via the at least one second transmitting pipeline, so that the gas raw material can be transmitted to the device main body.

10. The coating apparatus according to claim 1, wherein the device main body further comprises a power supply device and a chamber body, the chamber body is provided with a chamber, the liquid feeding device and the gas feeding device are both configured to communicate with the chamber of the chamber body to transmit the gas raw material to the chamber, and the power supply device is configured to provide a voltage to apply on the gas raw material in the chamber, such that the film can be prepared on the surface of the substrate by a chemical vapor deposition.

11. The coating apparatus according to claim 8, wherein the device main body further comprises a power supply device and a chamber body, the chamber body is provided with a chamber, the liquid feeding device and the gas feeding device are both configured to communicate with the chamber of the chamber body to transmit the gas raw material to the chamber, the power supply device is configured to provide a voltage to apply on the gas raw material in the chamber, such that the film can be prepared on the surface of the substrate by a chemical vapor deposition.

12. The coating apparatus according to claim 11, wherein the power supply device comprises a radio frequency power supply configured to provide a radio frequency electric field to apply on the gas raw material in the chamber.

13. The coating apparatus according to claim 11, wherein the power supply device comprises a pulse power supply configured to provide a pulse voltage to apply on the gas raw material in the chamber.

14. The coating apparatus according to claim 11, wherein the power supply device comprises a radio frequency power supply and a pulse power supply, wherein the radio frequency power supply is configured to provide a radio frequency electric field to discharge the gas raw material in the chamber to form a plasma environment and make reactant gases in a high-energy state, and the pulse power supply is configured to provide a pulse voltage to deposit gas particles in a high-energy state to form the film.

15. The coating apparatus according to claim 14, wherein the device main body further comprises a support, wherein the support is configured in the chamber of the chamber body to support the substrate, a positive terminal of the pulse power supply is configured to be electrically coupled with the chamber and grounded, while a negative terminal of the pulse power supply is configured to be electrically coupled with the support, and the support is insulated from the chamber.

16. The coating apparatus according to claim 1, wherein the gas raw material is a raw material for preparing a diamond-like carbon film, which is provided to the coating apparatus to prepare the diamond-like carbon film.

17. A coating method of a coating apparatus, comprising a step A: forming a first film layer on a surface of a substrate, wherein the step A comprises:
A1. transmitting a gas raw material to a device main body; and
A2. forming the first film layer on the surface of the substrate by using the device main body based on the gas raw material.

18. The coating method according to claim 17, wherein the step A is replaced by a step B: forming a second film layer on the surface of the substrate, wherein the step B comprises:
B1. gasifying a liquid raw material into a gas raw material and transmitting the gas raw material to the device main body; and
B2. forming the second film layer on the surface of the substrate by using the device main body based on the gas raw material.

19. The coating method according to claim 18, wherein the coating method comprises the step A and the step B, which are executed successively to prepare the first film layer and the second film layer on the surface of the substrate, or the step A is executed after the step B to prepare the second film layer and the first film layer successively on the surface of the substrate.

20. The coating method according to claim 17, wherein the step A is replaced by a step C: forming a third film layer on the surface of the substrate, wherein the step C comprises:
C1. transmitting a gas raw material to the device main body, and gasifying a liquid raw material into a gas raw material and transmitting the gas raw material to the device main body; and
C2. forming the third film layer on the surface of the substrate by using the device main body based on the gas raw materials.

21. The coating method according to claim 20, wherein the coating method comprises the step A and the step C which are executed successively, or the step A is executed after the step C.

22. The coating method according to claim 20, further comprising a step B: preparing a second film layer on the surface of the substrate, wherein the step B comprises:
B1. gasifying a liquid raw material into a gas raw material and transmitting the gas raw material to the device main body; and
B2. forming the second film layer on the surface of the substrate by using the device main body based on the gas raw material.

23. The coating method according to claim 21, further comprising a step B: preparing a second film layer on the surface of the substrate, wherein the step B comprises:
B1. gasifying a liquid raw material into a gas raw material and transmitting the gas raw material to the device main body; and
B2. forming the second film layer on the surface of the substrate by using the device main body based on the gas raw material.

24. The coating method according to claim 17, wherein the step A1 comprises:
A11. storing the gas raw material in a gas storage device; and
A12. transmitting the gas raw material to a chamber of the device main body.

25. The coating method according to claim 18, wherein the step B1 comprises:
B11. storing the liquid raw material in a liquid storage device; and
B12. gasifying the liquid raw material into the gas raw material and transmitting the gas raw material to a chamber of the device main body.

26. The coating method according to claim 20, wherein the step C1 comprises:
C11. storing the liquid raw material in a liquid storage device and storing the gas raw material in a gas storage device;
C12. transmitting the gas raw material to a chamber of the device main body; and
C13. gasifying the liquid raw material into the gas raw material and transmitting the gas raw material to the chamber.

27. The coating method according to claim 26, wherein the step C12 is executed after the step C13, or the step C12 and the step C13 are executed simultaneously.

28. The coating method according to claim 26, wherein the liquid raw material is gasified into the gas raw material by means of heating or depressurization.

29. The coating method according to claim 17, wherein the step A2 comprises: providing a radio frequency electric field to apply on the gas raw material to form the first film layer.

30. The coating method according to claim 18, wherein the step B2 comprises: providing a pulse voltage to apply on the gas raw material to form the second film layer.

31. The coating method according to claim 20, wherein the step C2 comprises: providing a radio frequency electric field to discharge the gas raw materials to form a plasma environment and making reactant gases in a high-energy state, and providing a pulse voltage to deposit gas particles in a high-energy state to form the third film layer.
